# EUROPEAN PATENT SPECIFICATION

(11) **EP 0 160 530 B1**
(45) Date of publication and mention of the grant of the patent: **08.09.1993**
(21) Application number: 85302930.4
(22) Date of filing: 25.04.1985
(51) Int. Cl.: H01R 23/66, H01R 9/07, H05K 1/00

(54) **Printed circuit boards and terminal devices therefor**
Leiterplatten und End-Steckverbinderanordnungen für dieselben
Plaquettes à circuit imprimé et dispositifs de terminal pour celles-ci

(30) Priority: 25.04.1984 JP 83332/84
(43) Date of publication of application: 06.11.1985
(73) Proprietor: SONY CORPORATION, Tokyo 141 (JP)
(72) Inventor: Sato, Hideo c/o Sony Corporation, Shinagawa-ku Tokyo (JP)
(74) Representative: Cotter, Ivan John

(56) References cited:
- EP-A- 0 065 425
- GB-A- 2 059 187
- US-A- 3 248 779
- US-A- 4 072 377

## Description

This invention relates to printed circuit boards and printed circuit board terminal devices.

Plasma display panels of X-Y matrix type are known as means for displaying characters or images. An x-electrode group (data electrodes) comprises anodes to which high and low voltages are applied corresponding to display data, that is data to be displayed. A y-electrode group (scanning electrodes) comprises cathodes which are scanned in line sequential manner with a negative voltage pulse.

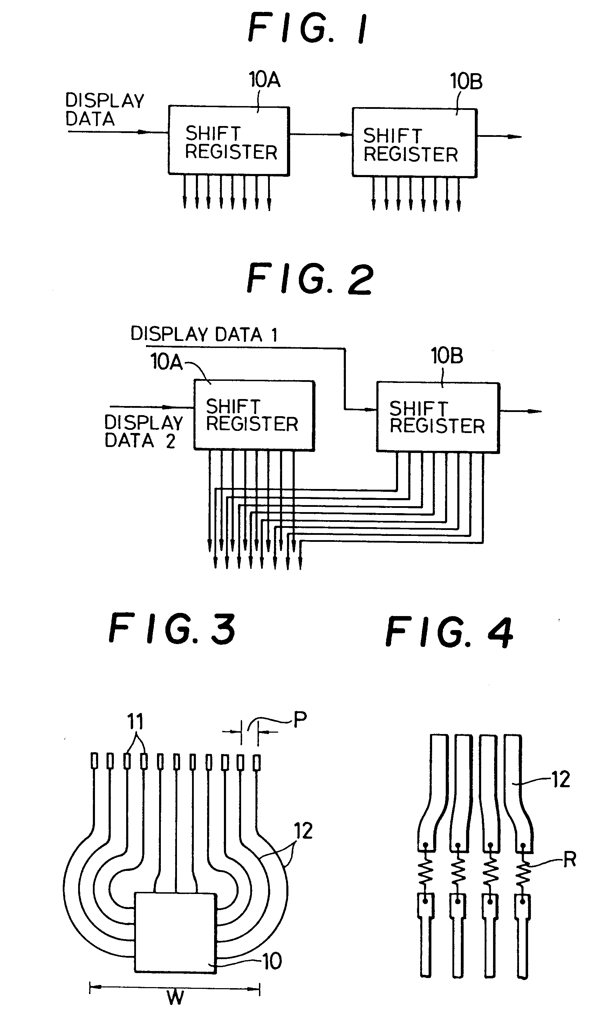

As shown in Figure 1 of the accompanying drawings, an inner drive circuit for such plasma display panels comprises shift registers 10A and 10B and a drive stage for converting serial display data into parallel data. However, if the integration density of the discharge electrodes is increased so as to improve the resolving power of a display panel, the number of stages of the shift register will be increased according to the increase in the number of anodes and the transfer speed of the shift register becomes inadequate.

In view of this fact, the display data can be converted into two bit parallel data and then supplied to parallel shift registers 10A and 10B, as illustrated in Figure 2. For this arrangement, parallel output lines of the shift registers 10A and 10B must be arranged alternately, as shown in Figure 2, so that they can be connected to extending portions of the anodes of the display panel. Electrical connections between the circuit and the panel generally are accomplished by a flexible printed circuit board on which drive integrated circuits (ICs) are mounted. For this reason, with the arrangement of Figure 2, both surfaces of the printed circuit board must be provided with printed circuit patterns and the terminal or inserting portions of conductor lines of the printed circuit must be formed using plated through holes, which results in high cost and low reliability.

With the arrangement illustrated in Figure 1, when the electrodes are arranged so that they have a very fine pitch between them, the pitch p of connecting terminals 11 (Figure 3) of a flexible printed circuit board will becomes so small as to reach the limit of manufacturing. For this reason, as is illustrated in Figure 3, conductor lines 12 between an integrated circuit (IC) 10 and the terminals 11 must be formed so that the conductor lines extend out from at least two side portions of the IC. Therefore, the size of the flexible printed circuit board will be large as compared to the width W of the plasma display panel.

Also, as illustrated in Figure 4, since discharge load resistors R must be inserted in the lines 12 between the anode drivers and the anodes, the pattern pitch of the resistor attaching portions must be increased and, therefore, it is difficult to mount the anode drive circuit on a flexible printed circuit board which is of the same size as the plasma display panel.

Document US-A- 4 072 377 discloses a terminal block including a printed circuit element with a central closely spaced row of terminal pads connected by conductive paths, deposited on one of its surfaces and extending from both sides thereof, to more widely spaced terminals surrounding respective openings. In one embodiment, the printed circuit element is a rigid board and terminals are mounted on the board and extend through each opening and project outwardly on the opposite surface of the board; in another embodiment, the circuit element is a flat, flexible sheet which is disposed against a support board provided with apertures aligned with the openings in the flexible sheet.

According to the invention there is provided a printed circuit board of flexible material mounting a first driver; a second driver; a lead terminal section formed with terminal patterns which extend in a planar line, are closely spaced and have a pitch "p"; a first plurality of planar signal output lines formed on one side of the lead terminal section, extending parallel to each other with pitch of "2p" and connected to a first group of alternate ones of the terminal patterns on the lead terminal section and to the first driver, the first signal output lines and the first group of alternate ones of the terminal patterns lying in a first plane; and a second plurality of planar signal output lines formed on a second side of the lead terminal section, extending parallel to each other with a pitch of "2p" and connected to a second group of alternate ones of the terminal patterns on the lead terminal section and to the second driver, the second signal output lines and the second group of terminal patterns lying in a second plane; wherein a first portion of the printed circuit board upon which the first driver is mounted can be bent so as to lie in a different plane to the lead terminal section and a second portion of the printed circuit board upon which the second driver is mounted can be bent so as to lie in a different plane to the lead terminal section, a first plurality of resistors being mounted on the printed circuit board in series with the first plurality of signal output lines and a second plurality of resistors being mounted on the printed circuit board in series with the second plurality of signal output lines.

Preferred embodiments of the present invention described hereinbelow provide a printed circuit board terminal device that can be coupled easily and reliably to an array of terminal pads (e.g. an array of electrode terminals on a plasma display panel) having very fine pitch and that has a reduced wiring area thereby achieving highly integrated circuit mounting.

The invention will now be further described, by way of illustrative and non-limiting example, with reference to the accompanying drawings, in which:-
Figures 1 and 2 are circuit diagrams of anode drive circuits for a plasma display panel, which circuits can be coupled to the panel by a previously proposed printed circuit board terminal device;
Figures 3 and 4 are partial plan views showing the structure of a connecting pattern of the previously proposed device;
Figure 5 is a plan view schematically illustrating a plasma display panel to which printed circuit board terminal devices embodying the present invention can be applied;
Figure 6 is a partial sectional view of the plasma display panel shown in Figure 5;
Figure 7 is a circuit diagram of an anode drive circuit shown in Figure 5, showing a circuit configuration of a printed circuit board terminal device embodying the present invention;
Figure 8 is a perspective view of the printed circuit board terminal device embodying the present invention;
Figure 9 is an enlarged partial plan view showing a wiring pattern of Figure 8 in detail;
Figure 10 is an enlarged partial plan view of a wiring pattern of the circuit of Figure 8;
Figure 11 is a perspective view illustrating a method of mounting a flexible printed circuit board illustrated in Figure 8;
Figure 12 is an enlarged partial sectional view showing a method of connecting electrode terminals;
Figure 13 is an enlarged partial sectional view illustrating an alternative method of connecting electrode terminals;
Figure 14 is a partial plan view illustrating a circuit portion of Figure 8 in detail; and

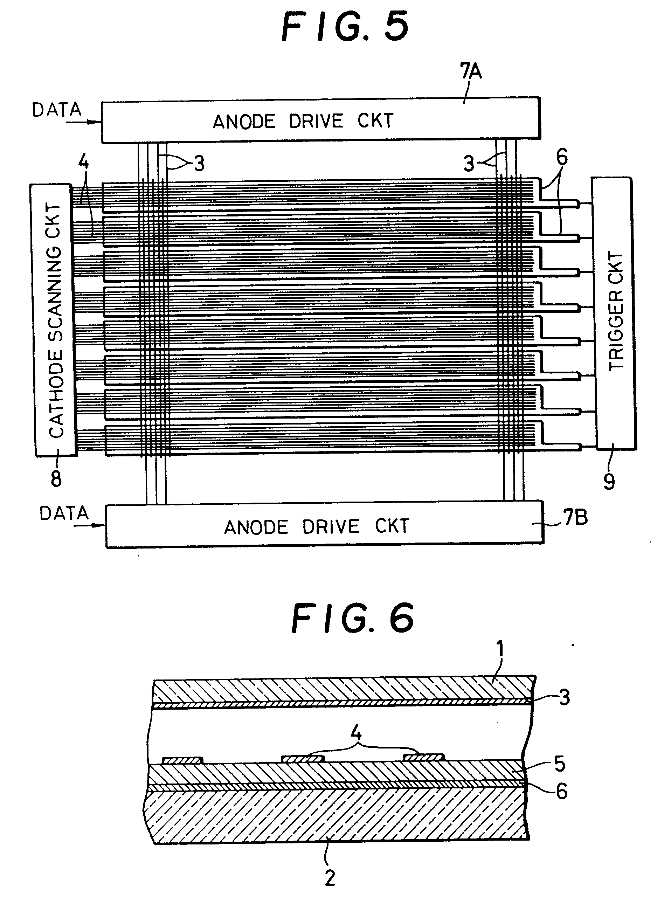

Figure 5 is a schematic plan view illustrating a plasma display panel (POP) to which printed circuit board terminal devices embodying the present invention can be applied. Figure 6 is a partial sectional view of the plasma display panel, which comprises a front glass panel 1 separated from a rear glass panel 2. Anodes 3 (which are data electrodes) and cathodes 4 (which are scanning electrodes) are mounted between the glass panels 1 and 2. The anodes 3 and cathodes 4 extend in x-y matrix form and are spaced apart with small discharge gaps between them. Trigger electrodes 6 are divided into a plurality of phases (for example eight phases) and are arranged under and parallel to the cathodes 4.

Alternate ones of the anodes 3 are coupled to an upper anode drive circuit 7A and the other alternate anodes 3 are coupled to a lower anode drive circuit 7B. Data voltages having either a high level ("1) or a low level ("0") corresponding to the display data (data to be displayed) are supplied to the anodes 3 in synchronism with scanning of the cathodes 4 using a shift register with parallel output and switching outputs derived from output switching elements in the drive circuits 7A and 7B according to the desired display data input, which is in serial form.

A negative voltage is applied to the cathodes 4 by a cathode scanning circuit 8 from the lower side to the higher side in a line sequential manner. A discharge is produced between a selected cathode 4 and a selected anode 3 to which a high voltage is applied.

The trigger electrodes 6 are driven by a trigger circuit 9 in a phase sequential manner, high voltage trigger pulses being supplied to the trigger electrode 6 in synchronism with the timing of the cathode scanning. Trigger discharges which induce discharges are generated between the trigger electrodes 6 and the opposing cathodes 4: the breakdown voltage between an anode 3 and a cathode 4 is decreased by spatial ions due to the discharge, thereby inducing a main discharge between the anode 3 and the cathode 4.

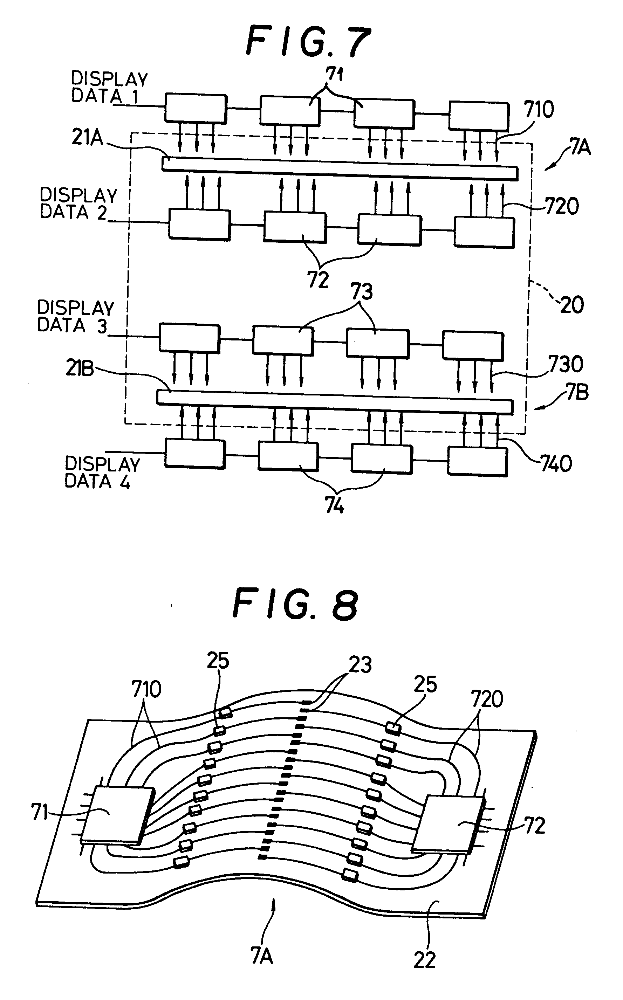

Figure 7 illustrates schematically the anode drive circuits 7A and 7B of Figure 5. In Figure 7, the outer dimensions of the display panel 20 are indicated by a dotted line. Lead terminal sections 21A and 21B for the anodes 3 are, as shown, mounted at upper and lower edges of the display panel 20. The drive circuit 7A is separated into drivers 71 and drivers 72 which are mounted on opposite sides of the lead terminal section 21A, two-bit parallel display data 1 and 2 being supplied to the corresponding drivers as illustrated. The drive circuit 7B is separated into drivers 73 and drivers 74 which are mounted on opposite sides of the lead terminal section 21B as illustrated, two-bit parallel display data 3 and 4 being supplied thereto. Thus, in this example, four-bit parallel display data is supplied to the drivers.

The drivers 71 to 74 comprise shift registers and driver transistors which are driven by parallel outputs of the shift registers and are formed by several integrated circuits. Signal output lines 710 of the drivers 71 are alternately connected to the lead terminal section 21A one by one. Likewise, signal output lines 720 of the drivers 72 are individually connected to the lead terminal section 21A as shown. Furthermore, the drivers 73 are connected by signal output lines 730 to the lead terminal section 21B one by one, and the drivers 74 are connected by output signal lines 740 to the lead terminal sections 21B of the panel 20. The pitch pattern ("2p") of the signal output lines 710, 720 and 730 and 740 is twice that ("p") of the lead terminal section 21A and 21B of the panel 20 because, as shown, the output lines extend to the lead terminal sections 21A and 21B from opposite sides thereof.

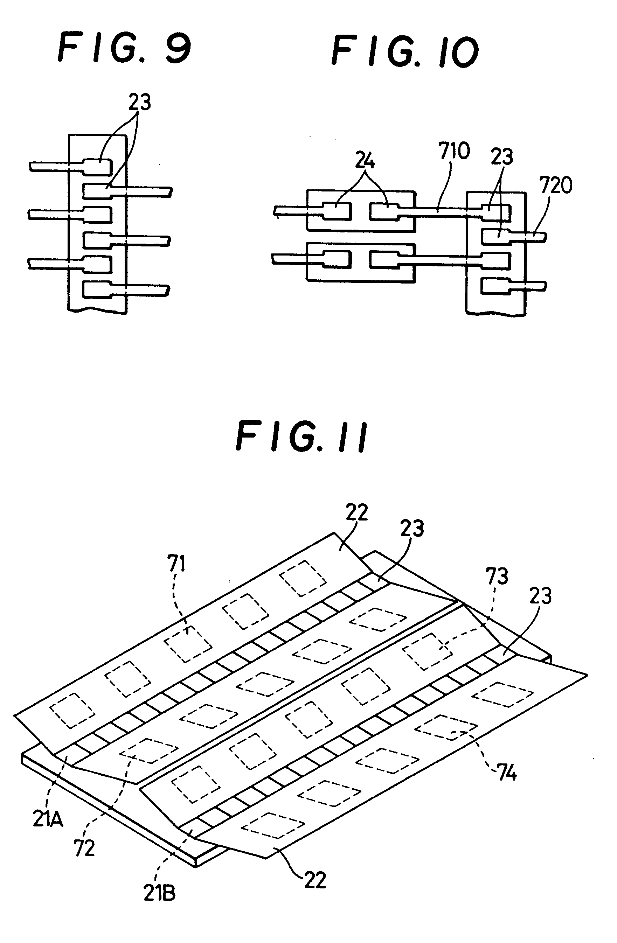

Figure 8 is a perspective view illustrating a method of mounting the upper anode drive circuit 7A. The integrated circuits constituting the drivers 71 and 72 and the signal output lines 710 and 720 are provided on a single surface of a flexible printed circuit board 22. Between the drivers 71 and 72, terminal patterns 23 are formed with the same pitch ("p") as the terminals of the lead terminal sections 21A and 21B of the panel 20 shown in Figure 7. A detailed partial view of the terminal patterns 23 is illustrated in Figure 9. The terminal patterns 23 are alternately connected to the signal output lines 710 and 720 from the drivers 71 and 72.

Line patterns 24 for discharge load resistors, which are shown in detail in Figure 10, are mounted in the lines 710 and 720. Shift resistors 25 are formed thereon, as illustrated in Figure 8. The resistors 25 may be printed film resistors. Since the pattern pitch ("2p") of the signal output lines 710 and 720 is twice the pitch ("p") of the terminal patterns 23, the mounting or printing space for the resistors 25 can be maintained without increasing the pattern pitch.

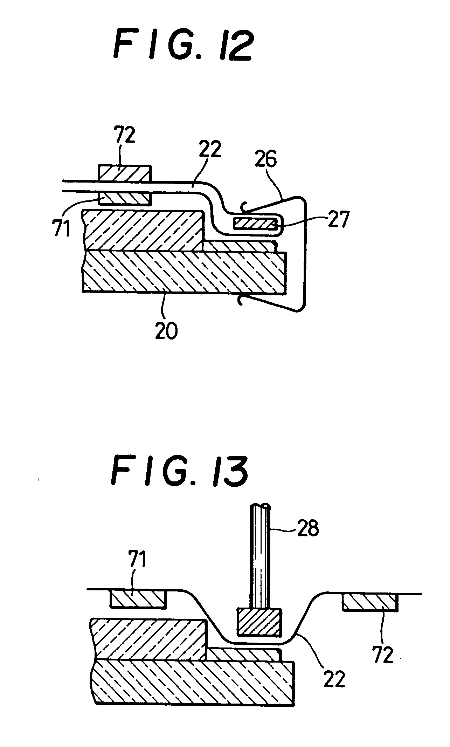

Figure 11 is a perspective view illustrating the method of mounting the flexible printed circuit board 22 on the display panel 20. The printed circuit board 22 illustrated in Figure 8 is turned over and connected such that the terminal patterns 23 coincide with the terminals of the lead terminal sections 21A and 21B.

The method of coupling can be a press coupling method using elastic spacers 27 and a press spring membr 26, as shown in partial sectional view in Figure 12. As shown, the flexible printed circuit board 22 is doubled over (bent or folded) around the elastic spacer 27 and the spring 26 clamps the flexible printed circuit board 22 to the display panel 20. It is to be noted that the drivers 71 and 72 will then be arranged as illustrated in Figure 12.

It should be realised, of course, that the terminal patterns 23 engage the associated terminal patterns of the lead terminal sections 21A.

An alternative method of coupling is illustrated in Figure 13. In this case the flexible printed circuit board 22 is soldered to the display panel 20 using a soldering tool 28. After the flexible printed circuit board 22 has been attached to the display panel 20, the board 22 can be bent over to the form illustrated in Figure 12 with the driver 72 adjacent the driver 71.

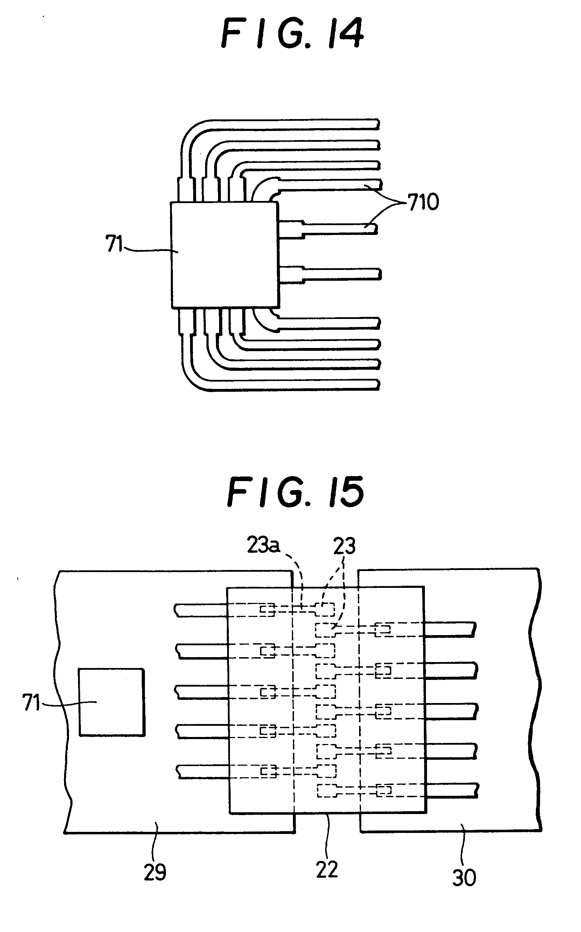

According to the above-described embodiments of the invention, since the pitch of the pattern of the signal output lines 710 to 740 from the driver circuits (ICs) is twice the conventional pitch of the lead terminal sections 21A and 21B, increased reliability and an increased manufacturing yield can be obtained. Figure 14 is a detailed view of an IC portion of the driver 71 and, since the output lines 710 need not be inserted alternately, they can be connected directly to the terminal patterns 23 without using lead wiring. High density integration within a small area is realised, and the width of the printed circuit board 22 can be the same as or smaller than that of the display panel 20.

It is to be noted that, after the flexible printed circuit board 22 has been connected to the terminal portions of the display panel 20, it can be folded as illustrated in Figure 12. The space required for mounting the drive circuits can be very small. The fixed positions of the ICs constituting the drivers 71 and 72 can be shifted so as to avoid their vertical overlapping each other, which permits a flatter structure. Alternatively, as illustrated in Figure 12, the ICs of the driver 71 can be fixed on the back surface of the pattern of the flexible printed circuit board 22 so that they extend in the same direction and are aligned as shown.

Thus, it can be seen that the above-described embodiments of the invention provide means for doubling the pitch of output leads on a flexible printed circuit board and extending them towards each other from opposite directions so that they can be connected to a circuit terminal array of which the pitch is one-half of that of the pitch of the leads extending from opposite directions on the flexible printed circuit board.

This structure allows low cost, high reliability and highly integrated mounting arrangements.

## Claims

1. A printed circuit board (22) of flexible material mounting a first driver (71); a second driver (72); a lead terminal section (21A) formed with terminal patterns (23) which extend in a planar line, are closely spaced and have a pitch "p"; a first plurality of planar signal output lines (710) formed on one side of the lead terminal section (21A), extending parallel to each other with pitch of "2p" and connected to a first group of alternate ones of the terminal patterns (23) on the lead terminal section and to the first driver (71), the first signal output lines (710) and the first group of alternate ones of the terminal patterns (23) lying in a first plane; and a second plurality of planar signal output lines (720) formed on a second side of the lead terminal section (21A), extending parallel to each other with a pitch of "2p" and connected to a second group of alternate ones of the terminal patterns (23) on the lead terminal section (21A) and to the second driver (72), the second signal output lines (720) and the second group of terminal patterns (23) lying in a second plane; wherein a first portion of the printed circuit board upon which the first driver (71) is mounted can be bent so as to lie in a different plane to the lead terminal section (21A) and a second portion of the printed circuit board upon which the second driver (72) is mounted can be bent so as to lie in a different plane to the lead terminal section (21A), a first plurality of resistors (25) being mounted on the printed circuit board in series with the first plurality of signal output lines (710) and a second plurality of resistors (25) being mounted on the printed circuit board in series with the second plurality of signal output lines (720).

## Patentansprüche

1. Gedruckte Leiterplatte (22) aus flexiblem Material für die Montage eines ersten Treibers (71) und eines zweiten Treibers (72),
mit einem Leiteranschlußbereich (21A) mit Anschlußmustern (23), die sich in einer ebenen Linie erstrecken und mit einem Teilungsabstand "p" eng benachbart angeordnet sind,
mit einer auf einer Seite des Leiteranschlußbereichs (21A) ausgebildeten ersten Mehrzahl von planaren Signalausgangsleitungen (710), die mit einem Teilungsabstand "2p" parallel zueinander verlaufen und mit einer ersten Gruppe von im Wechsel angeordneten Exemplaren der Anschlußmuster (23) auf dem Leiteranschlußbereich sowie mit dem ersten Treiber (71) verbunden sind, wobei diese ersten Signalausgangsleitungen (710) und die erste Gruppe von im Wechsel angeordneten Exemplaren der Anschlußmuster (23) in einer ersten Ebene liegen,
sowie mit einer auf einer zweiten Seite des Leiteranschlußbereichs (21A) ausgebildeten zweiten Mehrzahl von planaren Signalausgangsleitungen (720), die mit einem Teilungsabstand "2p" parallel zueinander verlaufen und mit einer zweiten Gruppe von im Wechsel angeordneten Exemplaren der Anschlußmuster (23) auf dem Leiteranschlußbereich sowie mit dem zweiten Treiber (72) verbunden sind, wobei diese zweiten Signalausgangsleitungen (710) und die zweite Gruppe von im Wechsel angeordneten Exemplaren der Anschlußmuster (23) in einer zweiten Ebene liegen,
wobei ein erster Abschnitt der gedruckten Leiterplatte, auf dem der erste Treiber (71) montiert ist, so gebogen werden kann, daß er in einer anderen Ebene liegt als der Leiteranschlußbereich (21A),
wobei ein zweiter Abschnitt der gedruckten Leiterplatte, auf dem der zweite Treiber (72) montiert ist, so gebogen werden kann, daß er in einer anderen Ebene liegt als der Leiteranschlußbereich (21A),
und wobei eine erste Mehrzahl von Widerständen (25) auf der gedruckten Leiterplatte in Reihe mit der ersten Mehrzahl von Signalausgangsleitungen (710) und eine zweite Mehrzahl von Widerständen (25) auf der gedruckten Leiterplatte in Reihe mit der zweiten Mehrzahl von Signalausgangsleitungen (720) angeordnet sind.

## Revendications

1. Plaquette de circuit imprimé (22) en un matériau souple destinée au montage d'un premier dispositif de commande (71), d'un second dispositif de commande (72), d'une section de borne de connexion (21A) formée par des motifs de borne (23) qui s'étendent selon une ligne plane, lesquels motifs sont faiblement espacés d'un pas "p" ; une première pluralité de lignes de sortie de signal planes (710) étant formées sur un côté de la section de borne de connexion (21A), s'étendant parallèlement les unes aux autres selon un pas "2p" et étant connectées à un premier groupe de motifs de borne alternés (23) prévu sur la section de borne de connexion ainsi qu'au premier dispositif de commande (71), les premières lignes de sortie de signal (710) et le premier groupe de motifs de borne alternés (23) étant situés dans un premier plan ; et une seconde pluralité de lignes de sortie de signal planes (720) étant formées sur un second côté de la section de borne de connexion (21A), s'étendant parallèlement les unes aux autres selon un pas "2p" et étant connectées à un second groupe de motifs de borne alternés (23) prévu sur la section de borne de connexion (21A) ainsi qu'au second dispositif de commande (72), les secondes lignes de sortie de signal (720) et le second groupe de motifs de borne (23) étant situés dans un second plan ; dans laquelle une première partie de la plaquette de circuit imprimé sur laquelle le premier dispositif de commande (71) est monté peut être recourbée de manière à être située dans un plan différent de celui de la section de borne de connexion (21A) et une seconde partie de la plaquette de circuit imprimé sur laquelle le second dispositif de commande (72) est monté peut être recourbée de manière à être située dans un plan différent de celui de la section de borne de connexion (21A), une première pluralité de résistances (25) étant montées sur la plaquette de circuit imprimé en série avec la première pluralité de lignes de sortie de signal (710) et une seconde pluralité de résistances (25) étant montées sur la plaquette de circuit imprimé en série avec la seconde pluralité de lignes de sortie de signal (720).
